# EUROPEAN PATENT SPECIFICATION

(11) **EP 1 455 194 B1**
(45) Date of publication and mention of the grant of the patent: **15.02.2006**
(21) Application number: 03445030.4
(22) Date of filing: 03.03.2003
(51) Int. Cl.: G01R 31/36, H02J 7/00

(54) **Apparatus and method for charging battery cells**
Vorrichtung und Verfahren zur Ladung von Batteriezellen
Dispositif et procédé pour charger des éléments de batterie

(43) Date of publication of application: 08.09.2004
(73) Proprietor: Sony Ericsson Mobile Communications AB, 221 88 Lund (SE)
(72) Inventor: Kalageropoulus, Sarandis, 211 54 Malmö (SE); Svensson, Jan-Olof, 261 63 Glumslöv (SE); L'Estrade, Christian, 252 49 Helsingborg (SE); Wolf, Mats, 247 35 Södra Sandby (SE)
(74) Representative: Lindberg, Olle Nils Olof

(56) References cited:
- EP-A- 1 164 682
- WO-A-02/093712
- US-A- 3 895 284
- US-A- 4 225 815
- US-A- 5 761 072
- US-A- 6 094 033
- US-A- 6 107 802
- US-A1- 2003 011 372
- US-B1- 6 242 893
- PATENT ABSTRACTS OF JAPAN vol. 2003, no. 03, 5 May 2003 (2003-05-05) & JP 2002 328154 A (HONDA MOTOR CO LTD), 15 November 2002 (2002-11-15)

## Description

### Field of the invention

The present invention relates to an apparatus and method for charging battery cells. In particular, the invention is applicable for charging lithium ion or lithium polymer battery cells, which are suitable to use as power supply in portable electronic apparatuses.

### Background

Lithium-based battery cells have started finding application as the batteries demonstrating higher performance than e.g. the nickel metal-hydride batteries. Lithium-based secondary battery cells have a high energy density, and have therefore widely become used in order to increase the battery usable or operable time. In particular, Lithium-based battery cells have been found useful in portable electronic devices, such as mobile phones, laptop computers and personal digital assistants PDAs. An example of such a lithium-based battery cell is a lithium-ion cell, and another lithium-based battery type having an even higher energy density is the lithium-polymer cell.

Lithium-based battery cells are unforgiving to overcharge. An overcharged lead acid battery will electrolyse some easily replaced water, and sealed nickelcadmium or metal-hydride batteries have voltages which stop rising at full charge, but the voltage of the lithium ion and lithium polymer battery cell continues to rise even while being overcharged. The voltage of a lithium ion battery cell rises quite distinctly at the end of charge. One characterising feature with the lithium-based cells is that these battery cells will not stand such overcharging, and consequently overcharging must be avoided. Overcharging can be visualised as depleting too many of the lithium ions off of the positive electrode. Upon overcharging performance degradation occurs.

A way of overcoming the risk for overcharging, with resulting damage to the battery cell, has been to use a two-step charging process known as Constant Current Constant Voltage CCCV. Usually, the constant voltage CV of a lithium cell is 4.2 V. With the CCCV method, the battery cell is first charged with a constant current until the voltage in the cell reaches 4.2 V. Once this level has been reached, a charging control system regulates the charging of the cell at 4.2 V in the subsequent step, and proceeds with the charging until the charging current has dropped to a predetermined current value. Once the predetermined current level has been detected or a given time limit has been reached, the cell is assumed to be fully charged.

However, lithium-based battery cells are not only sensitive to overcharging, they are sensitive to high voltage storing and charging as such. This means that the longer the battery is on high voltage the more it will deteriorate in cycle life. One attempt to overcome this problem has been to simply lower the CV to e.g. 4.1 V. On the other hand, with such a solution the capacity of the battery cell will inevitably decrease, due to the lower charging voltage.

A problem with the charging according to the CCCV method is that the current decreases exponentially during the CV phase, wherein the current decreases at a slower rate the closer it gets to the predetermined value. This means that the battery cell will be held at a high voltage during a prolonged time, during which damage may be caused to the cell. An effect of the current-controlled charging process time is that a higher charge will be applied in the first cycles of the battery cell life. The battery cell also ages faster in the beginning of its battery life, and in a later stage of the battery life, a smaller charge will be transmitted to the cell when using the same current control procedure. Accordingly, this results in shorter battery time between charging, as the battery cell gets older.

The prior art US-A-6,107,802 shows another battery charging method wherein the battery capacity is detected by a battery capacity detect circuit. The latter is operable to perform numerous monitoring operations on the battery by detecting the charge input to the battery and detecting charge taken away from the battery in a discharge operation. However, the charging method known from this prior art is unable to adapt termination of charging such as to increase the useful lifetime of the battery.

Consequently, there is still a need for improvements in the art of battery cells that are sensitive to high voltage, satisfying the market demands on cycle life and high capacity, i.e. battery time.

### Summary of the invention

Hence, it is an object of the present invention to overcome the above-identified deficiencies related to the prior art.

According to a first aspect, this object is fulfilled by an apparatus for charging a battery cell, said device comprising current control means for delivering a charging current until a predetermined charging voltage value is reached, a charging status detector devised to sense a charging parameter value, and charging control means arranged to terminate charging dependent on a predetermined charging criteria related to said charging parameter, wherein said charging criteria is a charge level value.

Said charging control means comprises a charging control device for establishing a charge measurement value, and a charging terminator devised to terminate charging dependent on said charge measurement value and said charge level value.

Said charging control device is arranged to detect a cutoff measurement value of the charging current, measured by said charging current measuring unit, when said charge measurement value has reached said charge level value. The control device further comprises means for comparing said cutoff measurement value with a predetermined cutoff value, wherein said charging control device is arranged to adapt said charge level value dependent on said comparison.

Preferably, said charging parameter value includes a measurement of charging time provided by a time measuring unit.

In one embodiment, a charging current measuring unit of the apparatus is devised to provide a measurement of charging current, wherein said charging control device is arranged to establish a charge measurement value by calculation using said measurement of charging time and said measurement of charging current.

Preferably, said charging control device is arranged to integrate said measurement of charging current over charging time, as provided by said time measuring unit.

Advantageously, the apparatus further includes a consumption current measuring unit, devised to provide a measurement of consumption current, wherein said charging control device is arranged to establish a charge measurement value by calculation using a measurement of consumption time, provided by said time measuring unit, and said measurement of consumption current.

Preferably, said charging control device is arranged to integrate said measurement of consumption current over consumption time, as provided by said time measuring unit.

In one embodiment, said charging control device is connected to a charging status logging means, and devised to store an established charge measurement value in said charging status logging means.

Preferably, said charging control device is arranged to establish an actual charge value by combining a stored charge measurement value, and a charge measurement value dependent on an integrated current over time, during which time the charge in the battery cell has changed from said stored charge measurement value.

Preferably, said charging control device is arranged to decrease said charge level value if said cutoff measurement value is lower than said predetermined cutoff value. The control device is in one embodiment arranged to decrease said charge level value by a predetermined charge value, and in another embodiment by a predetermined percentage thereof.

In another particular embodiment, said charging control device is arranged to detect a cutoff measurement value of the charging current, measured by said charging current measuring unit, when said charge measurement value has reached said charge level value. The control device further comprises means for comparing said cutoff measurement value with a predetermined cutoff value, wherein said charging control device is arranged to switch to an auxiliary charging scheme dependent on said comparison.

Said auxiliary charging scheme is in one embodiment targeted to terminate charging when said charging current reaches said predetermined cutoff value. In another embodiment said auxiliary charging scheme is targeted to terminate charging after a preset charging time has lapsed.

The apparatus may be included in a portable electronic apparatus, to which said battery cell is attachable.

Alternatively, the apparatus may be connected to said battery cell, wherein said device and said battery cell are included in a battery package casing.

In yet another alternative embodiment, said apparatus is included in a battery cell charger, attachable to said battery cell.

In a preferred embodiment, said apparatus is adapted for controlling charging of lithium-based battery cells.

Advantageously, said apparatus is adapted for controlling charging of lithium polymer battery cells or lithium ion battery cells.

According to a second aspect, the stated object is fulfilled by a method for charging a battery cell, comprising the steps of:
- detecting a voltage in said battery cell;
- supplying a charging current to said battery cell until predetermined charging voltage level value is reached;
- establishing a charge measurement value of a charge delivered to said battery cell by said charging current; and
- terminating the supply of said charging current dependent on said measurement value and a predetermined charge level value.
- detecting a cutoff measurement value of the charging current, measured by said charging current measuring unit, when said charge measurement value has reached said charge level value;
- comparing said cutoff measurement value with a predetermined cutoff value; and
- adapting said charge level value dependent on said comparison.

In one embodiment, said method further comprises the steps of:
- establishing said charge measurement value of the charge delivered by using a measurement of charging time.

Advantageously, said method comprises the steps of:
- measuring the charging current; and
- establishing said charge measurement value of the charge delivered by calculation using said measurement of charging time and said measurement of charging current.

Preferably, said method comprises the steps of:
- measuring the charging current; and
- establishing said charge measurement value of the charge delivered by integration of said measurement of the charging current over the charging time.

In one embodiment, said method comprises the steps of:
- establishing a charge measurement value of the charge drained from said battery cell by using a measurement of consumption time.

Advantageously, said method comprises the steps of:
- measuring a consumption current; and
- establishing a charge measurement value of the charge drained from said battery cell by calculation using said measurement of consumption time and said measurement of consumption current.

Preferably, said method comprises the steps of:
- measuring a consumption current; and
- establishing a charge measurement value of the charge drained from said battery cell by integration of said measurement of the consumption current over consumption time.

In one embodiment, said method comprises the step of:
- storing an established charge measurement value in charging status logging means.

In a preferred embodiment, said method comprises the steps of:
- retrieving a stored charge measurement value;
- establishing an actual charge value by combining a charge measurement value dependent on an integrated current over time, and the retrieved charge measurement value; and
- updating said charging status logging means by storing said actual charge value.

In one embodiment, said method comprises the steps of:
- monitoring said actual charge value; and
- terminating charging when said actual charge value has reached said charge level value.

Preferably, said method comprises the step of:
- first providing a constant charging current to said battery cell, until a voltage in said battery cell is increased to said predetermined charging voltage level value.

Preferably, the method comprises the step of:
- decreasing said charge level value if said cutoff measurement value is lower than said predetermined cutoff value.

In one embodiment, the method comprises the step of:
- decreasing said charge level value by a predetermined charge value.

In another embodiment, the method comprises the step of:
- decreasing said charge level value by a predetermined percentage thereof.

In another particular embodiment, said method comprises the steps of:
- detecting a cutoff measurement value of the charging current, measured by said charging current measuring unit, when said charge measurement value has reached said charge level value;
- comparing said cutoff measurement value with a predetermined cutoff value,; and
- switching to an auxiliary charging scheme dependent on said comparison.

In one embodiment the method comprises the step of:
- targeting termination of charging in said auxiliary charging scheme to when said charging current falls to said predetermined cutoff value.

In another particular embodiment, said method comprises the steps of:
- targeting termination of charging in said auxiliary charging scheme to when a preset charging time has lapsed.

In a preferred embodiment, said method is used for controlling charging of lithium-based battery cells.

Advantageously, said method apparatus is used for controlling charging of lithium polymer battery cells or lithium ion battery cells.

### Brief description of the drawings

The present invention will now be described in more detail with reference to preferred embodiments, given only by way of example and illustrated in the accompanying drawings, in which:
Fig. 1 schematically illustrates an exemplary embodiment of an apparatus according to the invention;
Fig. 2 illustrates a diagram showing measured discharge capacity for a battery cell charged according to a first embodiment of the invention, and a corresponding measurement of a battery cell charged according to a prior art procedure; and
Fig. 3 illustrates a diagram showing measured discharge capacity for a battery cell charged according to a second embodiment of the invention.

### Detailed description of preferred embodiments

The present description refers to battery cells for use with electronic equipment, such as communication or data processing terminals. One type of communication terminal for which the invention is suitable is portable radio communication terminals, such as mobile phones. However, the invention is applicable to many types of electronic devices, particularly portable electronic devices, such as pagers, communicators, electronic organisers, smartphones, PDA:s (Personal Digital Assistants), laptop computers, and so on. Furthermore, it should be emphasised that the term comprising or comprises, when used in this description and in the appended claims to indicate included features, elements or steps, is in no way to be interpreted as excluding the presence of other features elements or steps than those expressly stated.

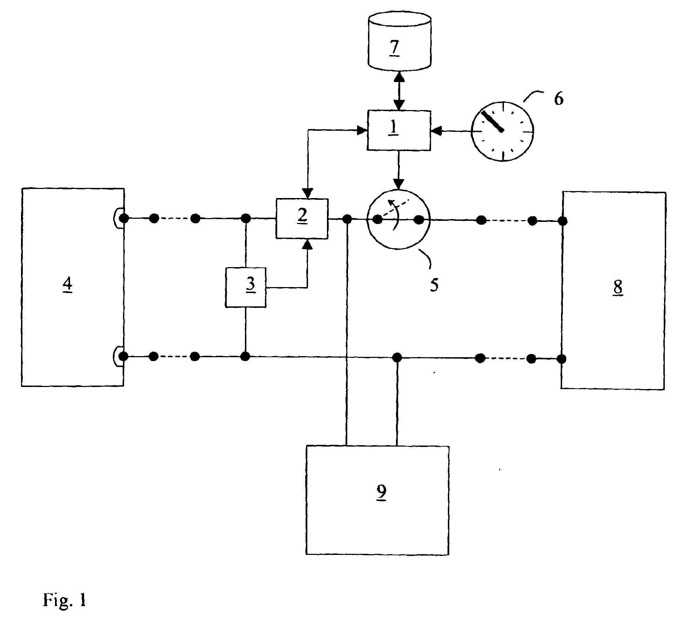

Fig. 1 illustrates an embodiment of the apparatus according to the invention. It should be stressed that the elements of the drawing are illustrated as functional items with communicative interconnections, which means that they do not necessarily represent physical entities. Means for calculating and controlling a process or device may be realised in hardware, but may also in many cases be realised by a microprocessor system with associated software. The present invention may thus include both hardware and software.

The apparatus for controlling charging of a battery cell may be implemented in an electronic device, such as a mobile phone. Alternatively, the apparatus is contained in a casing carrying the battery. Another alternative is to implement the apparatus in a charger, which is connectable to a power supply, such as a mains outlet.

Fig. 1 illustrates a battery cell 4, which can be Li-Ion or Li polymer, having two poles. As is indicated by the dashed lines to the left in the drawing, the battery cell 4 is connectable to the apparatus for charging the battery cell 4. At the other end, a power supply 8 is depicted, which may be a battery cell charger connectable to an electronic device carrying the apparatus and the battery cell 4. Power supply 8 consequently supplies the apparatus for charging the battery cell 4 with electrical energy. When charging the battery cell 4, a modified procedure according to CCCV is used. A charging terminator 5 is included in the form of a switch 5, which can be set to an open state for breaking the charging connection to the battery cell 4. A voltage measuring or monitoring device 3 senses the voltage over the battery cell 4. A current control means 2 is connected to at least one of the battery pole connections.

When the battery 4 is to be charged, a first charging phase is performed with a constant current, which is controlled by said control means 2. Upon supply of said constant current, voltage monitoring device 3 senses the voltage over the battery cell 4, which voltage will rise as the charging proceeds. When the voltage has reached a predetermined charging voltage level value, which for the example of a lithium polymer or Li-Ion battery cell may be 4.2 V, this voltage is sensed by voltage monitoring device 3 and reported to the current control unit 2, as is indicated by the arrow connecting the two elements in the drawing.

Once the charging voltage level value has been reached, the charging proceeds according to a constant voltage procedure. As the battery cell is charged at the charging voltage level value, the battery cell 4 will continuously decrease the charging current. In this phase of the charging, a target value or level should be used for determining when the charging should be terminated, since it is not desirable to apply a high voltage to the battery cell longer than necessary, due to the degradation this might cause. According to the invention, the current-controlled constant voltage part of the charging is targeted for the total charge of the battery cell. In other words, the charging proceeds until it is determined that a predetermined charge level has been reached. This is accomplished by a charging control device 1, which detects and measures the current passing to the battery cell 4. In the exemplary drawing it is indicated that the current control unit 2 also acts as a charging current measuring unit, devised to provide a measurement of charging current. However, in an alternative embodiment this measurement of charging current may be obtained by a separate unit. Furthermore, the charging control device 1 is connected to a time measuring unit 6. The charging control device 1 calculates the charge delivered to the battery cell 4 during charging, by integrating the measured charging current over the charging time. This way, a charge measurement value is obtained, relating to the amount of charge delivered to the battery cell 4.

Once the charging control device detects that the total charge in the battery cell 4 has reached said predetermined charge level, it triggers the charging terminator 5 to stop feeding current to the battery cell 4.

When the electronic device carrying the apparatus of the invention is used as intended, e.g. for calling in the case of a mobile phone, power will be drained from the battery cell 4 by the electronics 9 of the electronic device. Also in this operative mode, the current taken from the battery cell 4 is measured by a consumption current measuring unit. In the exemplary drawing it is indicated that the current control unit 2 also acts as a consumption current measuring unit, devised to provide a measurement of consumed current from the battery cell 4. However, in an alternative embodiment this measurement of consumption current may be obtained by a separate unit. The charging control device 1 integrates the detected consumed current over the consumption time, as detected by a time measuring unit 6, in this embodiment the same as used for the charging time. The integrated charge measurement value is e.g. useable for providing a battery charge warning to the user, as an indication that it is time to charge the battery cell 4. However, in this invention the charge measurement value relating to the amount of charge delivered from the battery cell 4 is also indirectly used for controlling the charging. A charging status logging means 7, including a memory for storing data on measured charge, is connected to the charging control device 1. Any change in the charge of the battery cell 4 is detected by the current measuring unit 2, and calculated by the charging control device 1. The present or actual charge value of the battery cell 4 is stored in the charging status logging means 7. When the battery cell is charged, the charge of the battery cell 4 increases by the measured charge value, which is then added to the actual charge value in the charging status logging means 7. Further, when the battery cell 4 is drained, the charge of the battery cell 4 decreases by the measured charge value, which is then subtracted from the actual charge value in the charging status logging means 7. This way, the actual charge value in the charging status logging means 7 is constantly updated, and it is this actual charge value that the charging control device 1 compares with the predetermined charge level, in order to determine when to trigger terminator 5 to stop the charging.

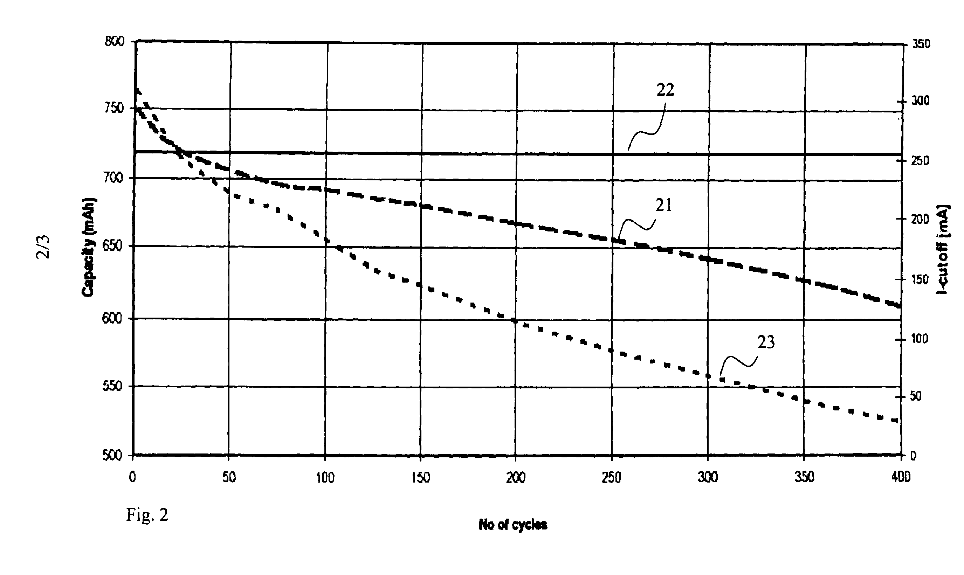

Fig. 2 illustrates a diagram over a total of 400 charging cycles for a 720 mAh lithium polymer battery cell, when charged according to a first embodiment of the invention, and when charged according to the prior art CCCV procedure. To the left side of the diagram, the vertical axis indicates the possible discharge capacity of the respective battery cell, i.e. the amount of charge that can be withdrawn from the battery after charging. To the right side of the diagram, the vertical axis indicates the charging current when the charging is terminated, the so called cutoff current.

The dashed line 21 indicates the discharge capacity, in mAh, for a battery cell charged according to the prior art, where a constant cutoff current of 50 mA has been used in every cycle. The cutoff current for the prior art case is not included in the drawing, but would obviously be represented by a horizontal line at 50 mA. It should be noted that the cutoff current should not be confused with the constant current during the CC phase of the charging. The cutoff current does not represent a constant current, but a current value obtained at the end of the CV phase. As is evident from the drawing, the discharge capacity in the early cycles clearly exceeds the stated capacity of 720 mAh. However, the high charging adds to the ageing effect on the battery cell, and after only about 30 cycles the discharge capacity has fallen to a level under the 720 mAh level. It is also evident that the discharge capacity will decrease constantly through every cycle.

In accordance with the invention, the charging is targeted by the discharge capacity, and therefore the discharge capacity will always be the same after each cycle, in this case 720 mAh. This is illustrated by the fully drawn line 22, indicating a measurement on a battery cell charged in accordance with this first embodiment of the invention. A benefit with the invention according to this first embodiment is consequently that the user will always know how much capacity he or she will have after a completed charging. The dotted line 23 indicates the measured cutoff current for the battery cell charged by the inventive procedure. As can be seen, it is far from constant. In fact, it will drop as the battery ages, since a longer charging time is needed to reach the targeted capacity.

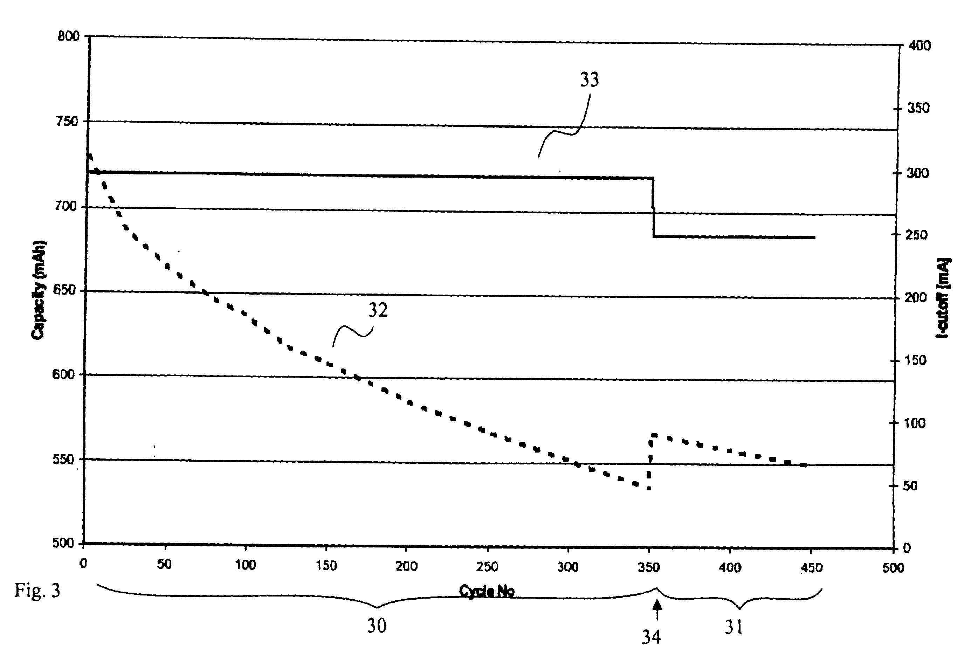

Fig. 3 illustrates a second embodiment of the invention in a diagram similar to that of Fig. 2, although the prior art discharge capacity curve is not shown. The dotted curve 32 in Fig. 3 represents a measured value of the cutoff current in a prototype device according to the invention, i.e. the value of the charging current when the target discharge capacity, or charge level value 33, has been reached. As a lithium-based battery cell ages, the charge time needed to reach the target discharge capacity increases. However, as previously outlined, the longer a lithium-based battery cell is subjected to a high voltage, the greater the risk for cycle life deterioration. At some point, it may be determined that the charging time has increased to a level where it might be harmful to the cell. In order to provide a safeguard against such a scenario, the second embodiment of the invention defines a constant voltage charging phase which is separated into two or more subphases, in the illustrated embodiment into two subphases. An auxiliary charging parameter has been added here compared to the embodiment of Fig. 2, namely the cutoff current.

During charging of the battery cell, the cutoff current is monitored by the current measuring unit 2, and as long as the cutoff current is larger than a predetermined cutoff value, the charging procedure is executed in same manner as in the process of Fig. 2. This is represented in Fig. 3 by subphase 30. Tests and simulations have shown that a cutoff current of down to 20 - 30 mA may be employed without seriously damaging a Lithium-based cell, but due to measurement accuracy and other factors a cutoff current value of 40 - 50 mA is suitably used as the predetermined cutoff value, i.e. the lowest allowable cutoff current this is also indicated in the drawing by the end value of the dotted cutoff current curve 32 in subphase 30, by an arrow at 34. The current measuring device 2 may be responsible for both measuring the actual cutoff current and comparing it to the predetermined cutoff value, and to report to the charging control device 1 when the cutoff value has been reached. Alternatively, the measured cutoff current is signalled to the charging control device 1 where the comparison is performed.

Once this point 34 is reached, i.e. when a cutoff current equal to or lower than the predetermined cutoff value has been detected, charging control device 1 decreases the target charge level value 33 by a predetermined step. This marks the start of a second subphase 31 of the constant voltage charging. In one embodiment, which as such is applicable also to the embodiment of Fig. 2, the charging status logging means 7 is used as a memory for storing the target discharge capacity or charge level value 33. When the current cutoff value is detected, charging control device 1 executes the decrease of the target discharge capacity value 33 by modifying the stored value in charging status logging means 7. In a particular embodiment, the decrease is executed by reducing the target discharge capacity value by a predetermined charge value, which may be 5 - 100 mAh, or more specifically 20 - 70 mAh, e.g. 50 mAh. In an alternative specific embodiment, the target discharge capacity value is reduced a certain percentage of its existing value, such as 1 - 20 %, or more specifically 2 - 10 %, e.g. 5 %.

In the illustrated example, the fully drawn line 33 represents the target discharge capacity, which should be read at the left side vertical axis, dependent on number of discharge cycles. In the prototype equipment on which the measurements of Fig. 3 where taken, a predetermined cutoff value of about 45 mA was reached after approximately 350 discharge cycles, indicated in the drawing by reference numeral 34. The target discharge capacity value was then reduced by 5 % from 720 mAh to 684 mAh. Thereby, the cutoff current 32 measured in the subsequent cycle was automatically increased by approximately 45 mA. However, the cutoff current will of course continue to decrease with every cycle, due to the ageing of the battery cell. This can also be clearly seen in Fig. 3. Needless to say, the levels given in Fig. 3 are merely exemplary.

In a particular variant of the embodiment of Fig. 3, the second subphase 31 will proceed in the same manner as the first subphase 30, meaning that if the cutoff current 32 once again falls below a predetermined cutoff value, a new decrease in the target discharge capacity value 33 is executed. The predetermined cutoff value and the target discharge capacity value reduction, for the second subphase 32, may be the same as for subphase 31, or different. Obviously, this process may be repeated for any desired number of subphases, until the end of the cycle life has been reached. This may e.g. be defined as a given percentage, e.g. 80 %, of the original discharge capacity value.

A benefit with this second embodiment of the invention, is that the cycle life characteristics may be improved even further compared to the first embodiment. The discharge capacity will be slightly lower once the target discharge capacity value is reduced, but the cycle life will be extended. Naturally, the charge time will also be decreased when the target discharge capacity value is reduced, which may be desirable to the user.

In an alternative variant of the second embodiment, also devised to guarantee that a predetermined cutoff value is not passed, the second subphase is not started by a reduction in the target discharge capacity value. Instead, once it has been detected that the cutoff current has reached the predetermined cutoff value, the charging in the second subphase is controlled by a traditional timer-based charging or a cutoff-based charging. This means that there will not be a sudden drop in the target discharge capacity value, but then again the charging controlled by e.g. a predetermined cutoff value in the second subphase will in most cases not result in the same extension of the cycle life as in the procedure suggested by Fig. 3. Still, the unnecessary overcharging associated with the prior art CV process is overcome in the first subphase when the target discharge capacity value is used to control the charging.

The foregoing has described the principles, preferred embodiments and modes of operation of the present invention. However, the invention should not be construed as being limited to the particular embodiments discussed above, which should be regarded as illustrative rather than restrictive. It should therefore be appreciated that variations may be made in those embodiments by workers skilled in the art without departing from the scope of the present invention, as defined by the following claims.

## Claims

1. Apparatus for charging a battery cell (4) according to a charging scheme, said device comprising current control means (2) for delivering a charging current, a charging status detector (2,6) devised to sense a charging parameter value, a charging control device (1) for establishing a charge measurement value, and a charging terminator (5) devised to terminate charging dependent on said charge measurement value and a predetermined charging criteria , **characterised in that** said charging criteria is a charge level value, and wherein said charging control device (1) comprises means for detecting a cutoff measurement value of the charging current when said charge measurement value has reached said charge level value, means for comparing said cutoff measurement value with a predetermined cutoff value, and means for adapting said charging scheme dependent on said comparison.

2. The apparatus as recited in claim 1, **characterised in that** said charging control device (1) is arranged to decrease said charge level value dependent on said comparison.

3. The apparatus as recited in claim 2, **characterised in that** said charging control device (1) is arranged to decrease said charge level value if said cutoff measurement value is lower than said predetermined cutoff value.

4. The apparatus as recited in claim 2 or 3, **characterised in that** said control device (1) is arranged to decrease said charge level value by a predetermined charge value.

5. The apparatus as recited in claim 2 or 3, **characterised in that** said control device (1) is arranged to decrease said charge level value by a predetermined percentage thereof.

6. The apparatus as recited in claim 1, **characterised in that** said charging control device (1) is arranged to switch to an auxiliary charging scheme dependent on said comparison.

7. The apparatus as recited in claim 6, **characterised in that** said auxiliary charging scheme is targeted to terminate charging when said charging current reaches said predetermined cutoff value.

8. The apparatus as recited in claim 6, **characterised in that** said auxiliary charging scheme is targeted to terminate charging after a preset charging time has lapsed.

9. The apparatus as recited in claim 1, **characterised in that** a charging current measuring unit (2) is devised to provide a measurement of charging current, and a time measuring unit (6) is devised to provide a measurement of charging time, wherein said charging control device (1) is arranged to establish a charge measurement value by calculation using said measurement of charging time and said measurement of charging current.

10. The apparatus as recited in claim 9, **characterised in that** said charging control device (1) is arranged to integrate said measurement of charging current over charging time.

11. The apparatus as recited in claim 9, **characterised in that** a consumption current measuring unit (2) is devised to provide a measurement of consumption current, wherein said charging control device (1) is arranged to establish a charge measurement value by calculation using a measurement of consumption time, provided by said time measuring unit (6), and said measurement of consumption current.

12. The apparatus as recited in claim 11, **characterised in that** said charging control device (1) is arranged to integrate said measurement of consumption current over consumption time.

13. The apparatus as recited in claim 1, **characterised in that** said charging control device (1) is connected to a charging status logging means (7), and devised to store an established charge measurement value in said charging status logging means.

14. The apparatus as recited in claim 13, **characterised in that** said charging control device (1) is arranged to establish an actual charge value by combining a stored charge measurement value, and a charge measurement value dependent on an integrated current over time.

15. The apparatus as recited in claim 14, **characterised in that** said charging control device (1) is arranged to control said charging terminator (5) to terminate charging when said actual charge value has reached said charge level value.

16. The apparatus as recited in any of the previous claims, **characterised in that** it is included in a portable electronic apparatus, to which said battery cell (4) is attachable.

17. The apparatus as recited in any of the previous claims 1-15, **characterised in that** it is connected to said battery cell (4), wherein said device and said battery cell are included in a battery package casing.

18. The apparatus as recited in any of the previous claims 1 - 15, **characterised in that** it is included in a battery cell charger, attachable to said battery cell (4).

19. The apparatus as recited in any of the previous claims, **characterised in that** it is adapted for controlling charging of lithium-based battery cells (4).

20. The apparatus as recited in any of the previous claims, **characterised in that** it is adapted for controlling charging of lithium polymer battery cells (4).

21. The apparatus as recited in any of the previous claims 1-19, **characterised in that** it is adapted for controlling charging of lithium Ion battery cells (4).

22. Method for charging a battery cell according to a charging scheme, comprising the steps of:
- supplying a charging current to said battery cell;
- establishing a charge measurement value of a charge delivered to said battery cell by said charging current;
- terminating the supply of said charging current dependent on said measurement value and a predetermined charge level value;
- detecting a cutoff measurement value of the charging current, when said charge measurement value has reached said charge level value;
- comparing said cutoff measurement value with a predetermined cutoff value; and
- adapting said charging scheme dependent on said comparison.

23. The method as recited in claim 22, wherein the step of adapting said charging scheme comprises the step of:
- decreasing said charge level value.

24. The method as recited in claim 23, comprising the steps of:
- decreasing said charge level value if said cutoff measurement value is lower than said predetermined cutoff value.

25. The method as recited in claim 23 or 24, comprising the steps of:
- decreasing said charge level value by a predetermined charge value.

26. The method as recited in claim 23 or 24, comprising the steps of:
- decreasing said charge level value by a predetermined percentage thereof.

27. The method as recited in claim 22, wherein the step of adapting said charging scheme comprises the step of:
- switching to an auxiliary charging scheme dependent on said comparison.

28. The method as recited in claim 27, comprising the steps of:
- targeting termination of charging in said auxiliary charging scheme to when said charging current falls to said predetermined cutoff value.

29. The method as recited in claim 27, comprising the steps of:
- targeting termination of charging in said auxiliary charging scheme to when a preset charging time has lapsed.

30. The method as recited in claim 22, comprising the steps of:
- measuring said charging current by means of a charging current measuring unit (2).

31. The method as recited in claim 22, comprising the steps of:
- calculating an actual charge value in said battery cell, dependent on said charge measurement value;
- comparing said actual charge value with said predetermined charge level value; and
- terminating the supply of said charging current when said actual charge value has reached said predetermined charge level value.

32. The method as recited in claim 22, comprising the step of:
- establishing said charge measurement value of the charge delivered by using a measurement of charging time.

33. The method as recited in claim 32, comprising the steps of:
- measuring the charging current; and
- establishing said charge measurement value of the charge delivered by calculation using said measurement of charging time and said measurement of charging current.

34. The method as recited in claim 32, comprising the steps of:
- measuring the charging current; and
- establishing said charge measurement value of the charge delivered by integration of said measurement of the charging current over the charging time.

35. The method as recited in claim 31, comprising the step of:
- establishing a charge measurement value of the charge drained from said battery cell by using a measurement of consumption time.

36. The method as recited in claim 35, comprising the steps of:
- measuring a consumption current; and
- establishing a charge measurement value of the charge drained from said battery cell by calculation using said measurement of consumption time and said measurement of consumption current.

37. The method as recited in claim 35, comprising the steps of:
- measuring a consumption current; and
- establishing a charge measurement value of the charge drained from said battery cell by integration of said measurement of the consumption current over consumption time.

38. The method as recited in any of the previous claims 22 - 37, comprising the step of:
- storing an established charge measurement value in charging status logging means.

39. The method as recited in claim 38 and claim 34 or 37, comprising the steps of:
- retrieving a stored charge measurement value;
- establishing an actual charge value by combining a charge measurement value dependent on an integrated current over time, and the retrieved charge measurement value; and
- updating said charging status logging means by storing said actual charge value.

40. The method as recited in claim 39, comprising the steps of:
- monitoring said actual charge value; and
- terminating charging when said actual charge value has reached said charge level value.

41. The method as recited in any of the previous claims 22 - 40, comprising the step of:
- first providing a constant charging current to said battery cell, until a voltage in said battery cell is increased to a predetermined charging voltage level value.

42. The method as recited in any of the previous claims 22-41, wherein said battery cell is lithium-based.

43. The method as recited in any of the previous claims 22 - 42, wherein said battery cell comprises a lithium polymer battery cell.

44. The method as recited in any of the previous claims 22 - 42, wherein said battery cell comprises a lithium Ion battery cell.

## Patentansprüche

1. Vorrichtung für das Aufladen einer Batteriezelle (4) gemäß einem Lade-Schema,
wobei die Vorrichtung umfasst:
Stromüberwachungs-Mittel (2) für das Liefern eines Ladestroms,
einen Ladestatus-Detektor (2,6), der vorgesehen ist, einen Lade-Parameter-Wert zu erfassen,
eine Lade-Steuerungsvorrichtung (1) für die Festlegung eines Lademesswerts, und einen Lade-Beendigungsvorrichtung (5) der vorgesehen ist, das Aufladen, abhängig vom Lademesswert und einem vorbestimmten Lade-Kriterium, zu beenden,
**dadurch gekennzeichnet, dass**
das Lade-Kriterium ein Ladepegelwert ist, und
wobei die Lade-Steuerungsvorrichtung (1) umfasst:
Mittel für das Erkennen eines Abschalt-Messwerts des Ladestroms, wenn der Lademesswert den Ladepegelwert erreicht hat,
Mittel für das Vergleichen des Abschalt-Messwerts mit einem vorbestimmten
Abschalt-Wert, und
Mittel für die Anpassung eines Lade-Schemas, abhängig von dem Vergleich.

2. Vorrichtung nach Anspruch 1,
**dadurch gekennzeichnet, dass**
die Lade-Steuerungsvorrichtung (1) so angepasst ist, den Ladepegelwert abhängig von dem Vergleich zu verringern.

3. Vorrichtung nach Anspruch 2,
**dadurch gekennzeichnet, dass**
wobei die Lade-Steuerungsvorrichtung (1) so angepasst ist, den Ladepegelwert zu verringern, wenn der Abschalt-Messwert niedriger ist als der vorbestimmte Abschalt-Wert.

4. Vorrichtung nach Anspruch 2 oder 3,
**dadurch gekennzeichnet, dass**
wobei Steuerungsvorrichtung (1) so angepasst ist, den Ladepegelwert um einen vorbestimmten Lade-Wert zu verringern.

5. Vorrichtung nach Anspruch 2 oder 3,
**dadurch gekennzeichnet, dass**
die Steuerungsvorrichtung (1) so angepasst ist, den Ladepegelwert um einen vorbestimmten Prozentsatz davon zu verringern.

6. Vorrichtung nach Anspruch 1,
**dadurch gekennzeichnet, dass**
die Lade-Steuerungsvorrichtung (1) so angepasst ist, zu einem Zusatz-Lade-Schema umzuschalten, abhängig von dem Vergleich.

7. Vorrichtung nach Anspruch 6,
**dadurch gekennzeichnet, dass**
das Zusatz-Lade-Schema so geplant ist, das Aufladen zu beenden, wenn der Ladestrom den vorbestimmten Abschalt-Wert erreicht.

8. Vorrichtung nach Anspruch 6,
**dadurch gekennzeichnet, dass**
das Zusatz-Lade-Schema so geplant ist, das Aufladen zu beenden, nachdem eine voreingestellte Ladezeit verstrichen ist.

9. Vorrichtung nach Anspruch 1,
**dadurch gekennzeichnet, dass**
eine Ladestrom-Messeinrichtung (2) vorgesehen ist, eine Messung des Ladestroms durchzuführen, und eine Zeit-Messeinrichtung (6) vorgesehen ist, eine Messung der Ladezeit durchzuführen, wobei die Lade-Steuerungsvorrichtung (1) so angepasst ist, um durch Berechnung einen Lademesswert aufzubauen unter Verwendung der Ladezeit und der Messung des Ladestroms.

10. Vorrichtung nach Anspruch 9,
**dadurch gekennzeichnet, dass**
die Lade-Steuerungsvorrichtung (1) so angepasst ist, die Messung des Ladestroms über die Ladezeit zu integrieren.

11. Vorrichtung nach Anspruch 10,
**dadurch gekennzeichnet, dass**
eine Stromverbrauchs-Messeinrichtung (2) vorgesehen ist, eine Stromverbrauchmessung bereitzustellen, wobei die Lade-Steuerungsvorrichtung (1) so angepasst ist, einen Lademesswert durch Berechnung aufzubauen, unter Verwendung einer Messung der Verbrauchszeit, bereitgestellt durch die Zeit-Messeinrichtung (6) und der Stromverbrauchmessung.

12. Vorrichtung nach Anspruch 11,
**dadurch gekennzeichnet, dass**
die Lade-Steuerungsvorrichtung (1) so angepasst ist, die Stromverbrauchmessung über die Verbrauchszeit zu integrieren.

13. Vorrichtung nach Anspruch 1,
**dadurch gekennzeichnet, dass**
die Lade-Steuerungsvorrichtung (1) mit einer Ladestatus-Einrichtung (7) verbunden
ist und dafür vorgesehen ist, einen feststehenden Lademesswert in der Ladestatus-Einrichtung zu speichern.

14. Vorrichtung nach Anspruch 13,
**dadurch gekennzeichnet, dass**
die Lade-Steuerungsvorrichtung (1) angepasst ist, einen aktuellen Lade-Wert durch das Kombinieren eines gespeicherten Lademesswerts und eines Lademesswerts, der von einem über die Zeit integrierten Strom abhängig ist, aufzubauen.

15. Vorrichtung nach Anspruch 14,
**dadurch gekennzeichnet, dass**
die Lade-Steuerungsvorrichtung (1) angepasst ist, die Lade-Beendigungsvorrichtung (5) anzusteuern, um das Aufladen zu beenden, wenn der aktuelle Lade-Wert den Ladepegelwert erreicht hat.

16. Vorrichtung nach einem der vorhergehenden Ansprüche,
**dadurch gekennzeichnet, dass**
sie in einer tragbaren elektronischen Vorrichtung enthalten ist, an die die Batteriezelle (4) anbringbar ist.

17. Vorrichtung nach einem der vorhergehenden Ansprüche 1-15,
**dadurch gekennzeichnet, dass**
sie mit der Batteriezelle (4) verbunden ist, wobei die Vorrichtung und die Batteriezelle in einem Batteriepaket-Gehäuse enthalten sind.

18. Vorrichtung nach einem der vorhergehenden Ansprüche 1-15,
**dadurch gekennzeichnet, dass**
sie in einem Batteriezellen-Ladegerät enthalten ist, die an die Batteriezelle (4) anbringbar ist.

19. Vorrichtung nach einem der vorhergehenden Ansprüche, **dadurch gekennzeichnet, dass** sie für die Ladesteuerung von Lithium-basierten Batteriezellen (4) vorgesehen ist.

20. Vorrichtung nach einem der vorhergehenden Ansprüche,
**dadurch gekennzeichnet, dass** sie für die Ladesteuerung von Lithium-Polymer-Batteriezellen (4) vorgesehen ist.

21. Vorrichtung nach einem der vorhergehenden Ansprüche 1-19, **dadurch gekennzeichnet, dass** sie für die Ladesteuerung von Lithium-Ionen-Batteriezellen (4) vorgesehen ist.

22. Verfahren für das Aufladen einer Batteriezelle gemäß einem Lade-Schema, das die Schritte umfasst für:
- das Liefern eines Ladestroms für die Batteriezelle;
- die Festlegung eines Lademesswerts für eine Ladung, die für die Batteriezelle über den Ladestrom geliefert wird;
- das Beenden der Versorgung mit Ladestrom abhängig vom Messwert und einem vorbestimmten Ladepegelwert;
- das Erkennen eines Abschalt-Messwerts des Ladestroms, wenn der Lademesswert den Ladepegelwert erreicht hat;
- das Vergleichen des Abschalt-Messwerts mit einem vorbestimmten Abschalt-Wert; und
- die Anpassung eines Lade-Schemas abhängig von dem Vergleich.

23. Verfahren nach Anspruch 22, wobei der Schritt zum Anpassen des Lade-Schemas den Schritt umfasst für:
- das Verringern des Ladepegelwerts.

24. Verfahren nach Anspruch 23, die Schritte umfassend für:
- das Verringern des Ladepegelwerts, wenn der Abschalt-Messwert niedriger als der vorbestimmte Abschalt-Wert ist.

25. Verfahren nach Anspruch 23 oder 24, die Schritte umfassend für:
- das Verringern des Ladepegeiwerts um einen vorbestimmten Lade-Wert.

26. Verfahren nach Anspruch 23 oder 24, die Schritte umfassend für:
- das Verringern des Ladepegeiwerts um einen vorbestimmten Prozentsatz davon.

27. Verfahren nach Anspruch 22, wobei der Schritt zum Anpassen des Lade-Schemas den Schritt umfasst für:
- das Umschalten zu einem Zusatz-Lade-Schema abhängig von dem Vergleich.

28. Verfahren nach Anspruch 27, die Schritte umfassend fiir:
- das Anvisieren der Beendigung des Aufladens im Zusatz-Lade-Schema, wenn das Aufladen unter den vorbestimmten Abschalt-Wert fällt.

29. Verfahren nach Anspruch 27, die Schritte umfassend für:
- das Anvisieren der Beendigung des Aufladens im Zusatz-Lade-Schema, wenn eine voreingestellte Ladezeit abgelaufen ist.

30. Verfahren nach Anspruch 22, die Schritte umfassend für:
- das Messen des Ladestroms mittels einer Ladestrom-Messeinrichtung (2).

31. Verfahren nach Anspruch 22, die Schritte umfassend für:
- das Berechnen eines aktuellen Lade-Werts für die Batteriezelle abhängig von dem Lademesswert;
- das Vergleichen des aktuellen Lade-Werts mit dem vorbestimmten Ladepegelwert; und
- das Beenden der Ladestromversorgung, wenn der aktuelle Lade-Wert den vorbestimmten Ladepegelwert erreicht hat.

32. Verfahren nach Anspruch 22, den Schritt umfassend für:
die Festlegung des Lademesswerts der gelieferten Ladung durch das Verwenden einer Messung der Ladezeit.

33. Verfahren nach Anspruch 32, die Schritte umfassend für:
- das Messen des Ladestroms; und
- die Festlegung des Lademesswerts der gelieferten Ladung durch Berechnung unter Verwendung der Ladezeitmessung und der Ladestrommessung.

34. Verfahren nach Anspruch 32, die Schritte umfassend für:
- das Messen des Ladestroms; und
- die Festlegung des Lademesswerts der gelieferten Ladung durch Integration der Ladestrom-Messung über die Ladezeit.

35. Verfahren nach Anspruch 31, den Schritt umfassend für:
- die Festlegung eines Lademesswerts für die Ladung, die aus der Batteriezelle entnommen wird, unter Verwendung der Verbrauchszeitmessung.

36. Verfahren nach Anspruch 35, die Schritte umfassend für:
- das Messen eines Stromverbrauchs; und
- die Festlegung eines Lademesswerts der aus der Batteriezelle entnommenen Ladung durch Berechnung unter Verwendung der Verbrauchszeitmessung und der Stromverbrauchmessung.

37. Verfahren nach Anspruch 35, die Schritte umfassend für:
- das Messen eines Stromverbrauchs; und
- die Festlegung eines Lademesswerts der aus der Batteriezelle entnommenen Ladung durch Integration der Stromverbrauchmessung über die Verbrauchszeit.

38. Verfahren nach einem der vorhergehenden Ansprüche 22-37, den Schritt umfassend für:
- das Speichern eines festgelegten Lademesswerts in einem Ladestatus-Protokollmittel.

39. Verfahren nach Anspruch 38 und dem Anspruch 34 oder 37, die Schritte umfassend für:
- das Abrufen eines gespeicherten Lademesswerts;
- die Festlegung eines aktuellen Lade-Werts durch das Kombinieren eines Lademesswerts abhängig von einer Integration des Stroms über die Zeit und des abgerufenen Lademesswerts; und
- die Aktualisierung des Ladestatus-Protokollmittels durch Speichern des aktuellen Lade-Werts.

40. Verfahren nach Anspruch 39, die Schritte umfassend für :
- das Überwachen des aktuellenLade-Werts; und
- das Beenden des Aufladens, wenn der aktuelle Lade-Wert den Ladepegelwert erreicht hat.

41. Verfahren nach einem der vorhergehenden Ansprüche 22-40 den Schritt umfassend für:
- das Bereitstellen eines konstanten Ladestroms für die Batteriezelle, bis eine Spannung in der Batteriezelle bis zu einem vorbestimmten Ladespannungspegel-Wert erhöht ist.

42. Verfahren nach einem der vorhergehenden Ansprüche 22-41, wobei die Batteriezelle Lithium-basiert ist.

43. Verfahren nach einem der vorhergehenden Ansprüche 22-42, wobei die Batteriezelle eine Lithium-Polymer-Batteriezelle umfasst.

44. Verfahren nach einem der vorhergehenden Ansprüche 22-42, wobei die Batteriezelle eine Lithium-Ionen-Batteriezelle umfasst.

## Revendications

1. Appareil destiné à charger un élément de batterie (4) conformément à un principe de charge, ledit dispositif comprenant un moyen de régulation de courant (2) destiné à délivrer un courant de charge, un détecteur d'état de charge (2, 6) conçu pour détecter une valeur de paramètre de charge, un dispositif de commande de charge (1) destiné à établir une valeur de mesure de charge, et un dispositif d'arrêt de charge (5) conçu pour mettre fin à une charge suivant ladite valeur de mesure de charge et un critère de charge prédéterminé, **caractérisé en ce que** ledit critère de charge est une valeur de niveau de charge, et dans lequel ledit dispositif de commande de charge (1) comprend un moyen destiné à détecter une valeur de mesure de coupure du courant de charge lorsque ladite valeur de mesure de charge a atteint ladite valeur de niveau de charge, un moyen destiné à comparer ladite valeur de mesure de coupure à une valeur de coupure prédéterminée, et un moyen destiné à adapter ledit principe de charge suivant ladite comparaison.

2. Appareil selon la revendication 1, **caractérisé en ce que** ledit dispositif de commande de charge (1) est agencé pour diminuer ladite valeur de niveau de charge suivant ladite comparaison.

3. Appareil selon la revendication 2, **caractérisé en ce que** ledit dispositif de commande de charge est agencé pour diminuer ladite valeur de niveau de charge si ladite valeur de mesure de coupure est inférieure à ladite valeur de coupure prédéterminée.

4. Appareil selon la revendication 2 ou 3, **caractérisé en ce que** ledit dispositif de commande (1) est agencé pour diminuer ladite valeur de niveau de charge d'une valeur de charge prédéterminée.

5. Appareil selon la revendication 2 ou 3, **caractérisé en ce que** ledit dispositif de commande (1) est agencé pour diminuer ladite valeur de niveau de charge d'un pourcentage prédéterminé de celle-ci.

6. Appareil selon la revendication 1, **caractérisé en ce que** ledit dispositif de commande de charge (1) est agencé pour basculer vers un principe de charge auxiliaire suivant ladite comparaison.

7. Appareil selon la revendication 6, **caractérisé en ce que** ledit principe de charge auxiliaire a pour cible de mettre fin à la charge lorsque ledit courant de charge atteint ladite valeur de coupure prédéterminée.

8. Appareil selon la revendication 6, **caractérisé en ce que** ledit principe de charge auxiliaire a pour cible de mettre fin à la charge après qu'un temps de charge préétabli s'est écoulé.

9. Appareil selon la revendication 1, **caractérisé en ce qu'**une unité de mesure de courant de charge (2) est conçue pour procurer une mesure d'un courant de charge, et une unité de mesure de temps (6) est conçue pour procurer une mesure du temps de charge, dans lequel ledit dispositif de commande de charge (1) est agencé pour établir une valeur de mesure de charge par un calcul en utilisant ladite mesure de temps de charge et ladite mesure de courant de charge.

10. Appareil selon la revendication 9, **caractérisé en ce que** ledit dispositif de commande de charge (1) est agencé pour intégrer ladite mesure de courant de charge par rapport à un temps de charge.

11. Appareil selon la revendication 9, **caractérisé en ce qu'**une unité de mesure de courant de consommation (2) est conçue pour procurer une mesure du courant de consommation, dans lequel ledit dispositif de commande de charge (1) est agencé pour établir une valeur de mesure de charge par le calcul en utilisant une mesure du temps de consommation, fournie par ladite unité de mesure de temps (6), et ladite mesure de courant de consommation.

12. Appareil selon la revendication 11, **caractérisé en ce que** ledit dispositif de commande de charge (1) est agencé pour intégrer ladite mesure de courant de consommation par rapport au temps de consommation.

13. Appareil selon la revendication 1, **caractérisé en ce que** ledit dispositif de commande de charge (1) est relié à un moyen de journalisation d'état de charge (7), et est conçu pour mémoriser une valeur de mesure de charge établie dans ledit moyen de journalisation d'état de charge.

14. Appareil selon la revendication 13, **caractérisé en ce que** ledit dispositif de commande de charge (1) est agencé pour établir une valeur de charge réelle en combinant une valeur de mesure de charge mémorisée et une valeur de mesure de charge suivant un courant intégré par rapport au temps.

15. Appareil selon la revendication 14, **caractérisé en ce que** ledit dispositif de commande de charge (1) est agencé pour commander ledit dispositif d'arrêt de charge (5) pour mettre fin à la charge lorsque ladite valeur de charge réelle a atteint ladite valeur de niveau de charge.

16. Appareil selon l'une quelconque des revendications précédentes, **caractérisé en ce qu'**il est inclus dans un appareil électronique portable, auquel ledit élément de batterie (4) peut être fixé.

17. Appareil selon l'une quelconque des revendications 1 à 15, **caractérisé en ce qu'**il est relié audit élément de batterie (4), dans lequel ledit dispositif et ledit élément de batterie sont inclus dans un boîtier de bloc de batterie.

18. Appareil selon l'une quelconque des revendications précédentes 1 à 15, **caractérisé en ce qu'**il est inclus dans un chargeur d'élément de batterie, pouvant être fixé audit élément de batterie (4).

19. Appareil selon l'une quelconque des revendications précédentes, **caractérisé en ce qu'**il est conçu pour commander la charge d'éléments de batterie à base de lithium (4).

20. Appareil selon l'une quelconque des revendications précédentes, **caractérisé en ce qu'**il est conçu pour commander la charge d'éléments de batterie au lithium-polymère (4).

21. Appareil selon l'une quelconque des revendications 1 à 19, **caractérisé en ce qu'**il est conçu pour commander la charge d'éléments de batterie à ions lithium (4).

22. Procédé de charge d'un élément de batterie selon un principe de charge, comprenant les étapes consistant à :
- fournir un courant de charge audit élément de batterie,
- établir une valeur de mesure de charge d'une charge délivrée audit élément de batterie par ledit courant de charge,
- arrêter la fourniture dudit courant de charge suivant ladite valeur de mesure et une valeur de niveau de charge prédéterminée,
- détecter une valeur de mesure de coupure du courant de charge, lorsque ladite valeur de mesure de charge a atteint ladite valeur de niveau de charge,
- comparer ladite valeur de mesure de coupure à une valeur de coupure prédéterminée, et
- adapter ledit principe de charge suivant ladite comparaison.

23. Procédé selon la revendication 22, dans lequel l'étape d'adaptation dudit principe de charge comprend l'étape consistant à :
- diminuer ladite valeur de niveau de charge.

24. Procédé selon la revendication 23, comprenant les étapes consistant à :
- diminuer ladite valeur de niveau de charge si ladite valeur de mesure de coupure est inférieure à ladite valeur de coupure prédéterminée.

25. Procédé selon la revendication 23 ou 24, comprenant les étapes consistant à :
- diminuer ladite valeur de niveau d'une valeur de charge prédéterminée.

26. Procédé selon la revendication 23 ou 24, comprenant les étapes consistant à :
- diminuer ladite valeur de niveau de charge d'un pourcentage prédéterminé de celle-ci.

27. Procédé selon la revendication 22, dans lequel l'étape d'adaptation dudit principe de charge comprend l'étape consistant à :
- basculer sur un principe de charge auxiliaire suivant ladite comparaison.

28. Procédé selon la revendication 27, comprenant les étapes consistant à :
- établir la cible de l'arrêt de charge dans ledit principe de charge auxiliaire au moment où le courant de charge chute à ladite valeur de coupure prédéterminée.

29. Procédé selon la revendication 27, comprenant les étapes consistant à :
- établir la cible d'arrêt de charge dans ledit principe de charge auxiliaire au moment où un temps de charge préétabli s'est écoulé.

30. Procédé selon la revendication 22, comprenant les étapes consistant à :
- mesurer ledit courant de charge au moyen d'une unité de mesure de courant de charge (2).

31. Procédé selon la revendication 22, comprenant les étapes consistant à :
- calculer une valeur de charge réelle dans ledit élément de batterie, suivant ladite valeur de mesure de charge,
- comparer ladite valeur de charge réelle à ladite valeur de niveau de charge prédéterminée, et
- mettre fin à la fourniture dudit courant de charge lorsque ladite valeur de charge réelle a atteint ladite valeur de niveau de charge prédéterminée.

32. Procédé selon la revendication 22, comprenant l'étape consistant à :
- établir ladite valeur de mesure de charge de la charge délivrée en utilisant une mesure d'un temps de charge.

33. Procédé selon la revendication 32, comprenant les étapes consistant à :
- mesurer le courant de charge, et
- établir ladite valeur de mesure de charge de la charge délivrée par un calcul en utilisant ladite mesure de temps de charge et ladite mesure de courant de charge.

34. Procédé selon la revendication 32, comprenant les étapes consistant à :
- mesurer le courant de charge, et
- établir ladite valeur de mesure de charge de la charge délivrée par une intégration de ladite mesure du courant de charge par rapport au temps de charge.

35. Procédé selon la revendication 31, comprenant l'étape consistant à :
- établir une valeur de mesure de charge de la charge consommée à partir dudit élément de batterie en utilisant une mesure d'un temps de consommation.

36. Procédé selon la revendication 35, comprenant les étapes consistant à :
- mesurer un courant de consommation, et
- établir une valeur de mesure de charge de la charge consommée depuis ledit élément de batterie par un calcul en utilisant ladite mesure de temps de consommation et ladite mesure de courant de consommation.

37. Procédé selon la revendication 35, comprenant les étapes consistant à :
- mesurer un courant de consommation, et
- établir une valeur de mesure de charge de la charge consommée à partir dudit élément de batterie par une intégration de ladite mesure du courant de consommation par rapport au temps de consommation.

38. Procédé selon l'une quelconque des revendications précédentes 22 à 37, comprenant l'étape consistant à :
- mémoriser une valeur de mesure de charge établie dans un moyen de journalisation d'état de charge.

39. Procédé selon la revendication 38 et la revendication 34 ou 37, comprenant les étapes consistant à :
- récupérer une valeur de mesure de charge mémorisée,
- établir une valeur de charge réelle en combinant une valeur de mesure de charge suivant un courant intégré par rapport au temps, et la valeur de mesure de charge récupérée, et
- mettre à jour ledit moyen de journalisation d'état de charge en mémorisant ladite valeur de charge réelle.

40. Procédé selon la revendication 39, comprenant les étapes consistant à :
- surveiller ladite valeur de charge réelle, et
- mettre fin à la charge lorsque ladite valeur de charge réelle a atteint ladite valeur de niveau de charge.

41. Procédé selon l'une quelconque des revendications précédentes 22 à 40, comprenant l'étape consistant à :
- procurer tout d'abord un courant de charge constant audit élément de batterie, jusqu'à ce qu'une tension dans ledit élément de batterie soit augmentée à une valeur de niveau de tension de charge prédéterminée.

42. Procédé selon l'une quelconque des revendications précédentes 22 à 41, dans lequel ledit élément de batterie est à base de lithium.

43. Procédé selon l'une quelconque des revendications précédentes 22 à 42, dans lequel ledit élément de batterie comprend un élément de batterie au lithium-polymère.

44. Procédé selon l'une quelconque des revendications précédentes 22 à 42, dans lequel ledit élément de batterie comprend un élément de batterie à ions lithium.
